(19) Europäisches Patentamt
European Patent Office
Office européen des brevets

(11) **EP 4 645 396 A1**

(12) **EUROPEAN PATENT APPLICATION**
published in accordance with Art. 153(4) EPC

(43) Date of publication:
05.11.2025 Bulletin 2025/45

(21) Application number: 23911234.5

(22) Date of filing: 01.08.2023

(51) International Patent Classification (IPC):
*H01L 33/50* (2010.01)    *C09K 11/08* (2006.01)
*C09K 11/59* (2006.01)    *C09K 11/61* (2006.01)
*C09K 11/62* (2006.01)    *C09K 11/64* (2006.01)
*C09K 11/79* (2006.01)    *C09K 11/80* (2006.01)
*C09K 11/85* (2006.01)    *F21K 9/60* (2016.01)
*F21K 9/64* (2016.01)    *F21S 41/125* (2018.01)
*F21S 41/141* (2018.01)    *F21S 41/176* (2018.01)
*F21V 9/38* (2018.01)    *F21W 102/00* (2018.01)
*F21W 102/30* (2018.01)    *F21W 103/15* (2018.01)
*F21W 103/20* (2018.01)    *F21W 103/35* (2018.01)
*F21W 103/45* (2018.01)

(52) Cooperative Patent Classification (CPC):
**H10H 20/8513; C09K 11/77346; F21K 9/60;**
**F21K 9/64; F21S 41/125; F21S 41/141;**
**F21S 41/176; F21S 43/16; G02B 5/20;**
**G02F 1/1336;** F21S 43/14; F21V 9/38;
F21W 2102/00; F21W 2102/30; F21W 2103/15;
(Cont.)

(86) International application number:
**PCT/JP2023/028196**

(87) International publication number:
**WO 2024/142450 (04.07.2024 Gazette 2024/27)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: 27.12.2022 JP 2022210189

(71) Applicants:
• **Mitsubishi Chemical Corporation**
  **Tokyo 100-8251 (JP)**

• **National Institute for Materials Science**
  **Tsukuba-shi, Ibaraki 305-0047 (JP)**

(72) Inventors:
• **INATA Yuhei**
  **Tokyo 100-8251 (JP)**
• **KURUSHIMA Tomoyuki**
  **Tokyo 100-8251 (JP)**
• **HIROSAKI Naoto**
  **Tsukuba-shi, Ibaraki 305-0047 (JP)**

(74) Representative: **Hoffmann Eitle**
**Patent- und Rechtsanwälte PartmbB**
**Arabellastraße 30**
**81925 München (DE)**

(54) **LIGHT-EMITTING DEVICE, LIGHTING DEVICE, IMAGE DISPLAY DEVICE, AND INDICATOR LAMP FOR VEHICLES**

(57)    The present invention addresses the problem of providing a light-emitting device, a lighting device, and an image display device and/or an indicator lamp for vehicles, for which at least one of any of the following is excellent: color rendering, color reproducibility, conversion efficiency, safety, and contrast. The present invention relates to a light-emitting device comprising a light-emitting element that comprises a first light-emitting body and a second light-emitting body that emits visible light due to irradiation with light from the first light-emitting body, wherein the light-emitting device has at least one or more emitted colors having a correlated color temperature of 4000 K or less. The second light-emitting body contains at least: one or more phosphors having an emission peak in the wavelength region from at least 450 nm to less than 600 nm, and one or more different

phosphors having an emission peak wavelength in the wavelength region from at least 600 nm to not more than 700 nm. For at least one of the emitted colors having a correlated color temperature of 4000 K or less, C/A is 0.25 or less where C is the emission intensity at 700 nm and A is the emission intensity at a wavelength $\lambda 1$ at which the emission intensity in the emission spectrum from at least 600 nm to not more than 700 nm is a maximum. An aforesaid different phosphor having an emission peak wavelength in the wavelength region from at least 600 nm to not more than 700 nm comprises at least a phosphor having a crystalline phase having a composition given by a prescribed formula.

*FIG. 1A*

(52) Cooperative Patent Classification (CPC): (Cont.)
F21W 2103/20; F21W 2103/35; F21W 2103/45;
F21Y 2115/10; H10H 29/24; H10H 29/30;
H10H 29/8513

**Description**

TECHNICAL FIELD

The present invention relates to a light-emitting device, an illumination device, an image display device, and an indicator lamp for a vehicle.

BACKGROUND ART

In recent years, a demand for a light-emitting device, an illumination device, an image display device, and/or an indicator lamp for a vehicle using an LED has increased in response to a trend toward energy conservation. The LED used in such devices is, for example, a white light-emitting LED in which a phosphor is disposed on an LED chip that emits light in blue or near-ultraviolet wavelengths.

An LED using, on a blue LED chip, a nitride phosphor that emits red light and a phosphor that emits green light, with blue light from the blue LED chip as excitation light, has been used for this type of white light-emitting LED in recent years. There is a demand for an LED having high color rendering, color reproducibility, and/or conversion efficiency.

For example, in an illumination application, there is a need for a light-emitting device that not only has high conversion efficiency but also high color rendering, that exhibits an emission spectrum close to that of natural light by which a color of an object that receives the light appears close to a natural color, and that is less stressful to the human eye.

CITATION LIST

NON-PATENT LITERATURE

Non-Patent Literature 1: J. Mater. Chem. C, 2015, Vol. 3, Issue 21, p. 5484-5489
Non-Patent Literature 2: Chemistry Letters, 2006, Vol. 35, No. 3, p. 334-335

SUMMARY OF INVENTION

TECHNICAL PROBLEM

Based on the above problems, in one aspect, an object of the present invention is to provide a light-emitting device, an illumination device, an image display device, and/or an indicator lamp for a vehicle which are favorable in any one or more of color rendering, color reproducibility, conversion efficiency, safety, and a contrast.

SOLUTION TO PROBLEM

After intensive study, the present inventors have found that a light-emitting device in which a ratio of an emission intensity in a plurality of specific wavelength regions or specific wavelengths is within a specific range can solve the above problem. Thus, the present invention has been accomplished. Some non-limiting embodiments are shown below. Note that the present invention also includes embodiments which further include some or all of features of one or more other embodiments with respect to any of the embodiments described below.

<1> A light-emitting device having at least one or more light emission colors having a correlated color temperature of 4000 K or lower, the light-emitting device comprising:

a light-emitting element including a first luminescent material and a second luminescent material which emits visible light by irradiation with light from the first luminescent material,
in which the second luminescent material contains at least one or more phosphors having an emission peak in a wavelength region of 450 nm or more and less than 600 nm, and one or more other phosphors having an emission peak wavelength in a wavelength region of 600 nm or more and 700 nm or less,
in at least one of the light emission colors having the correlated color temperature of 4000 K or lower, when an emission intensity at a wavelength $\lambda 1$ where an emission intensity of an emission spectrum is maximum at 600 nm or more and 700 nm or less is set to A, and an emission intensity at 700 nm is set to C, C/A is 0.25 or less, and the one or more other phosphors having the emission peak wavelength in the wavelength region of 600 nm or more and 700 nm or less include at least a phosphor containing a crystal phase having a composition represented by the following formula [1]:

$$Re_xMA_aMB_bMC_cN_dX_e \qquad [1]$$

wherein in formula [1] above, MA includes one or more elements selected from the group consisting of Sr, Ca, Ba, Na, K, Y, Gd, and La,
MB includes one or more elements selected from the group consisting of Li, Mg, and Zn,
MC includes one or more elements selected from the group consisting of Al, Si, Ga, In, and Sc,
X includes one or more elements selected from the group consisting of F, Cl, Br, and I,
Re includes one or more elements selected from the group consisting of Eu, Ce, Pr, Tb, and Dy, and
a, b, c, d, e, and x respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2.$$

<2> The light-emitting device according to the above <1>, in which when an emission intensity at 600 nm is set to B, B/A is 0.60 or more.
<3> A light-emitting device having at least one or more light emission colors having a correlated color temperature of 4000 K or lower, the light-emitting device comprising:

a light-emitting element including a first luminescent material and a second luminescent material which emits visible light by irradiation with light from the first luminescent material,
in which the second luminescent material contains at least one or more phosphors having an emission peak in a wavelength region of 450 nm or more and less than 600 nm, and one or more other phosphors having the emission peak wavelength in the wavelength region of 600 nm or more and 700 nm or less, and
in at least one of the light emission colors having the correlated color temperature of 4000 K or lower, when an emission intensity at a wavelength $\lambda 1$ where an emission intensity of an emission spectrum is maximum at 600 nm or more and 700 nm or less is set to A, an emission intensity at 600 nm is set to B, and an emission intensity at 700 nm is set to C, B/A is 0.60 or more and C/A is 0.20 or less.

<4> The light-emitting device according to any one of the above <1> to <3>, in which in at least one of the light emission colors having the correlated color temperature of 4000 K or lower, when an emission intensity at a wavelength $\lambda 3$ where the emission intensity of the emission spectrum is a local minimum in a wavelength region equal to or greater than an emission peak wavelength $\lambda 2$ of excitation light is set to D, a ratio D/A of the emission intensity D to the emission intensity A is 0.15 or more.
<5> The light-emitting device according to any one of the above <1> to <4>, in which in at least one of the light emission colors having the correlated color temperature of 4000 K or lower, the emission intensity of the emission spectrum continuously decreases from the wavelength $\lambda 1$ to 700 nm.
<6> The light-emitting device according to any one of the above <1> to <5>, in which a proportion of the one or more other phosphors having the emission peak wavelength in the wavelength region of 600 nm or more and 700 nm or less is 45 % by weight or less with respect to the second luminescent material.
<7> The light-emitting device according to any one of the above <1> to <6>, comprising a plurality of light-emitting elements having different light emission colors or color temperatures and a dimming device, and capable of exhibiting two or more different light emission colors.
<8> The light-emitting device according to any one of the above <1> to <7>, in which the one or more other phosphors having the emission peak wavelength in the wavelength region of 600 nm or more and 700 nm or less comprise a phosphor which does not substantially include Mn.

<9> The light-emitting device according to any one of the above <1> to <8>, in which the one or more other phosphors having the emission peak wavelength in the wavelength region of 600 nm or more and 700 nm or less comprise a phosphor which exhibits an emission peak wavelength in a wavelength region of 600 nm or more and 648 nm or less.

<10> The light-emitting device according to any one of the above <1> to <9>, in which the one or more other phosphors having the emission peak wavelength in the wavelength region of 600 nm or more and 700 nm or less comprise a phosphor having internal quantum efficiency of 30% or more.

<11> The light-emitting device according to any one of the above <1> to <10>, in which the one or more other phosphors having the emission peak wavelength in the wavelength region of 600 nm or more and 700 nm or less comprise a phosphor having a full width at half maximum in the emission spectrum of 57 nm or less.

<12> The light-emitting device according to any one of the above <1> to <11>, in which the one or more other phosphors having the emission peak wavelength in the wavelength region of 600 nm or more and 700 nm or less comprise a phosphor having a full width at half maximum in the emission spectrum of 20 nm or more.

<13> The light-emitting device according to any one of the above <1> to <12>, in which the one or more other phosphors having the emission peak wavelength in the wavelength region of 600 nm or more and 700 nm or less comprise a phosphor having an emission peak wavelength x (nm) and a full width at half maximum y (nm) in the emission spectrum satisfying a relationship $y \leq 184 - 0.2x$.

<14> The light-emitting device according to any one of the above <1> to <13>, in which the one or more other phosphors having the emission peak wavelength in the wavelength region of 600 nm or more and 700 nm or less comprise at least a phosphor containing a crystal phase having a composition represented by the following formula [2]:

$$Re_x MA_a MB_b (Al_{1-y} MC'_y)_c N_d X_e \qquad [2]$$

wherein in formula [2], MA includes one or more elements selected from the group consisting of Sr, Ca, Ba, Na, K, Y, Gd, and La,

MB includes one or more elements selected from the group consisting of Li, Mg, and Zn,

MC' includes one or more elements selected from the group consisting of Si, Ga, In, and Sc,

X includes one or more elements selected from the group consisting of F, Cl, Br, and I,

Re includes one or more elements selected from the group consisting of Eu, Ce, Pr, Tb, and Dy, and

a, b, c, d, e, x, and y respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2$$

$$0.0 < y \leq 1.0.$$

<15> The light-emitting device according to any one of the above <1> to <14>, in which the one or more phosphors having the emission peak in the wavelength region of 450 nm or more and less than 600 nm comprise any one or more of a garnet type phosphor, a silicate type phosphor, a nitride phosphor, and an oxynitride phosphor.

<16> An illumination device comprising the light-emitting device according to any one of the above <1> to <14> as a light source.

<17> An image display device comprising the light-emitting device according to any one of the above <1> to <14> as a light source.

<18> An indicator lamp for a vehicle comprising the light-emitting device according to any one of the above <1> to <14> as a light source.

<19> A luminescent material comprising at least

one or more phosphors having an emission peak in a wavelength region of 450 nm or more and less than 600 nm; and

one or more other phosphors having the emission peak wavelength in the wavelength region of 600 nm or more and 700 nm or less,

in which in an emission spectrum which exhibits a light emission color having a correlated color temperature of 4000 K or lower during excitation with blue light and which exhibits the light emission color having the correlated color temperature of 4000 K or lower, when an emission intensity at a wavelength $\lambda 1$ where an emission intensity is maximum at 600 nm or more and 700 nm or less is set to A, and an emission intensity at 700 nm is set to C, C/A is 0.25 or less, and

the one or more other phosphors having the emission peak wavelength in the wavelength region of 600 nm or more and 700 nm or less include at least a phosphor containing a crystal phase having a composition represented by the following formula [1]:

$$Re_x MA_a MB_b MC_c N_d X_e \qquad [1]$$

wherein in formula [1] above, MA includes one or more elements selected from the group consisting of Sr, Ca, Ba, Na, K, Y, Gd, and La,

MB includes one or more elements selected from the group consisting of Li, Mg, and Zn,

MC includes one or more elements selected from the group consisting of Al, Si, Ga, In, and Sc,

X includes one or more elements selected from the group consisting of F, Cl, Br, and I,

Re includes one or more elements selected from the group consisting of Eu, Ce, Pr, Tb, and Dy, and

a, b, c, d, e, and x respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2.$$

<20> The luminescent material according to the above <19>, in which when an emission intensity at 600 nm is set to B, B/A is 0.60 or more.

<21> A luminescent material containing at least

one or more phosphors having an emission peak in a wavelength region of 450 nm or more and less than 600 nm; and

one or more other phosphors having the emission peak wavelength in the wavelength region of 600 nm or more and 700 nm or less,

in which in an emission spectrum which exhibits a light emission color having a correlated color temperature of 4000 K or lower during excitation with blue light and which exhibits the light emission color having the correlated color temperature of 4000 K or lower, when an emission intensity at a wavelength $\lambda 1$ where an emission intensity is maximum at 600 nm or more and 700 nm or less is set to A, an emission intensity at 600 nm is set to B, and an emission intensity at 700 nm is set to C, B/A is 0.60 or more, and C/A is 0.20 or less.

<22> The luminescent material according to any one of the above <19> to <21>, in which in the emission spectrum which exhibits the light emission color having the correlated color temperature of 4000 K or lower, when an emission intensity at a wavelength where the emission intensity of the emission spectrum is a local minimum in a wavelength region equal to or greater than an emission peak wavelength $\lambda 2$ of excitation light is set to D, a ratio D/A of the emission intensity D to the emission intensity A is 0.15 or more.

<23> The luminescent material according to any one of the above <19> to <22>, in which a proportion of the one or more other phosphors having the emission peak wavelength in the wavelength region of 600 nm or more and 700 nm or less is 45 % by weight or less with respect to the luminescent material.

<24> The luminescent material according to any one of the above <19> to <23>, in which the one or more other phosphors having the emission peak wavelength in the wavelength region of 600 nm or more and 700 nm or less comprise a phosphor which does not substantially include Mn.

<25> The luminescent material according to any one of the above <19> to <24>, in which the one or more other phosphors having the emission peak wavelength in the wavelength region of 600 nm or more and 700 nm or less comprise a phosphor which exhibits an emission peak wavelength in a wavelength region of 600 nm or more and 648 nm or less.

<26> The luminescent material according to any one of the above <19> to <25>, in which the one or more other phosphors having the emission peak wavelength in the wavelength region of 600 nm or more and 700 nm or less comprise a phosphor having internal quantum efficiency of 30% or more.

<27> The luminescent material according to any one of the above <19> to <26>, in which the one or more other phosphors having the emission peak wavelength in the wavelength region of 600 nm or more and 700 nm or less comprise a phosphor having a full width at half maximum in the emission spectrum of 57 nm or less.

<28> The luminescent material according to any one of the above <19> to <27>, in which the one or more other phosphors having the emission peak wavelength in the wavelength region of 600 nm or more and 700 nm or less comprise a phosphor having a full width at half maximum in the emission spectrum of 20 nm or more.

<29> The luminescent material according to any one of the above <19> to <28>, in which the one or more other phosphors having the emission peak wavelength in the wavelength region of 600 nm or more and 700 nm or less comprise a phosphor having an emission peak wavelength x (nm) and a full width at half maximum y (nm) in the emission spectrum satisfying a relationship $y \leq 184-0.2x$.

<30> The luminescent material according to any one of the above <19> to <29>, in which the one or more other phosphors having the emission peak wavelength in the wavelength region of 600 nm or more and 700 nm or less comprise at least a phosphor containing a crystal phase having a composition represented by the following formula [2]:

$$Re_xMA_aMB_b(Al_{1-y}MC'_y)_cN_dX_e \qquad [2]$$

wherein in formula [2], MA includes one or more elements selected from the group consisting of Sr, Ca, Ba, Na, K, Y, Gd, and La,

MB includes one or more elements selected from the group consisting of Li, Mg, and Zn,

MC' includes one or more elements selected from the group consisting of Si, Ga, In, and Sc,

X includes one or more elements selected from the group consisting of F, Cl, Br, and I,

Re includes one or more elements selected from the group consisting of Eu, Ce, Pr, Tb, and Dy, and

a, b, c, d, e, x, and y respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2$$

$$0.0 < y \leq 1.0.$$

<31> The luminescent material according to any one of the above <19> to <30>, in which the one or more phosphors having the emission peak in the wavelength region of 450 nm or more and less than 600 nm comprise any one or more of a garnet type phosphor, a silicate type phosphor, a nitride phosphor, and an oxynitride phosphor.

EFFECTS OF INVENTION

In a plurality of embodiments, the present invention can provide a light-emitting device, an illumination device, an image display device, and/or an indicator lamp for a vehicle which are favorable in any one or more of color rendering, color reproducibility, conversion efficiency, safety, and a contrast.

BRIEF DESCRIPTION OF DRAWINGS

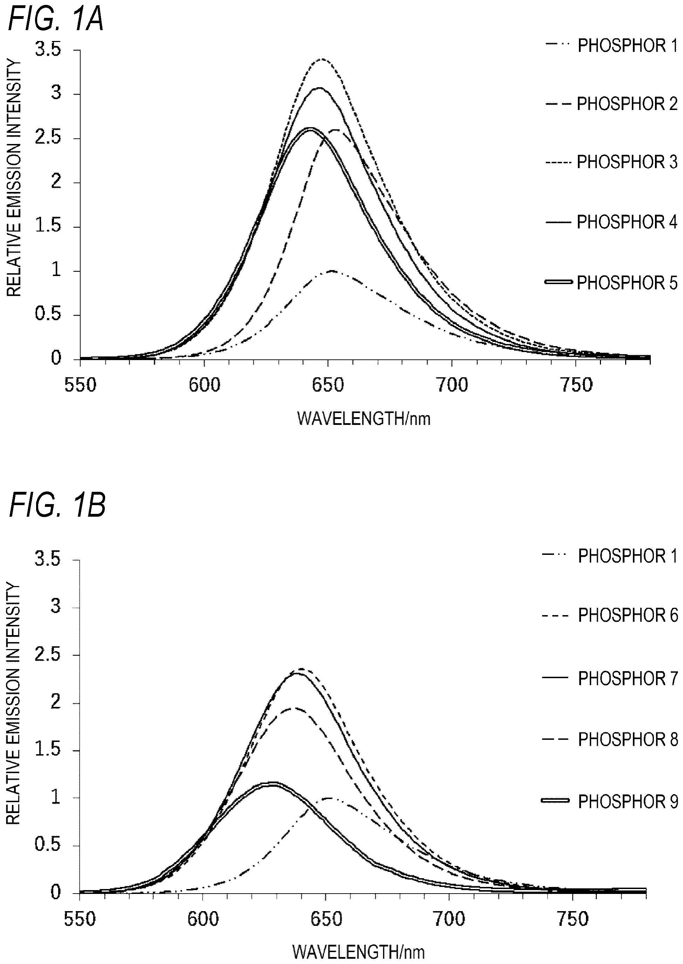

[Fig. 1A] Fig. 1A is a graph showing emission intensities of phosphors 1 to 5 when the emission intensity of phosphor 1 at an emission peak wavelength is set to 1.

[Fig. 1B] Fig. 1B is a graph showing emission intensities of phosphor 1 and phosphors 6 to 9 when the emission intensity of phosphor 1 at an emission peak wavelength is set to 1.

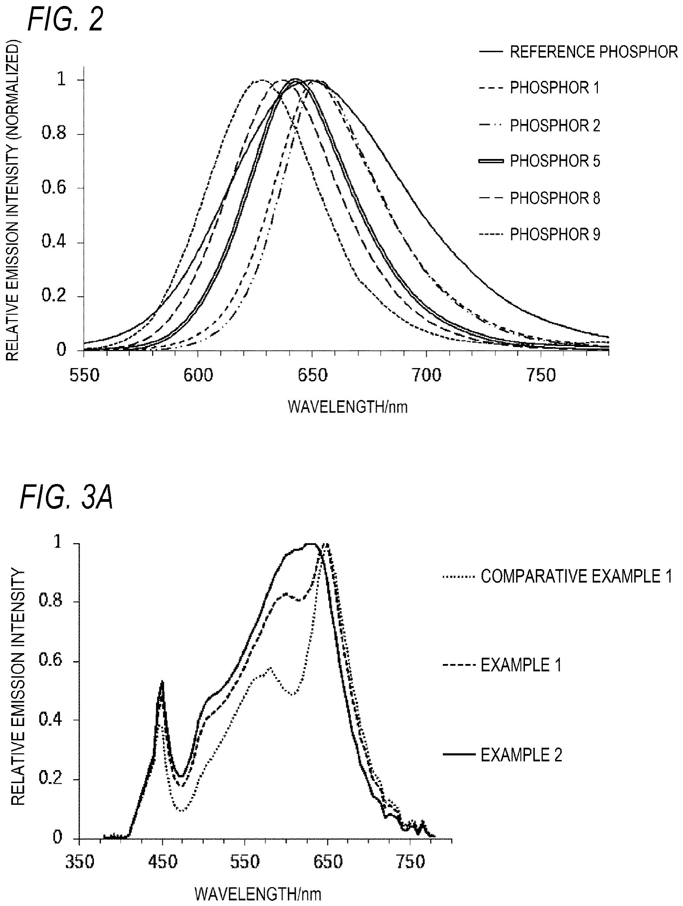

[Fig. 2] Fig. 2 is a graph showing normalized emission spectra of a reference phosphor and phosphors 1, 2, 5, 8, and 9.

[Fig. 3A] Fig. 3A is a graph showing white spectra in Comparative Example 1, Example 1, and Example 2 at CIE chromaticity coordinates (0.437, 0.404) and a color temperature of 3000 K output from a simulation, which are normalized with setting a maximum emission intensity in a range of 480 nm to 780 nm to 1.

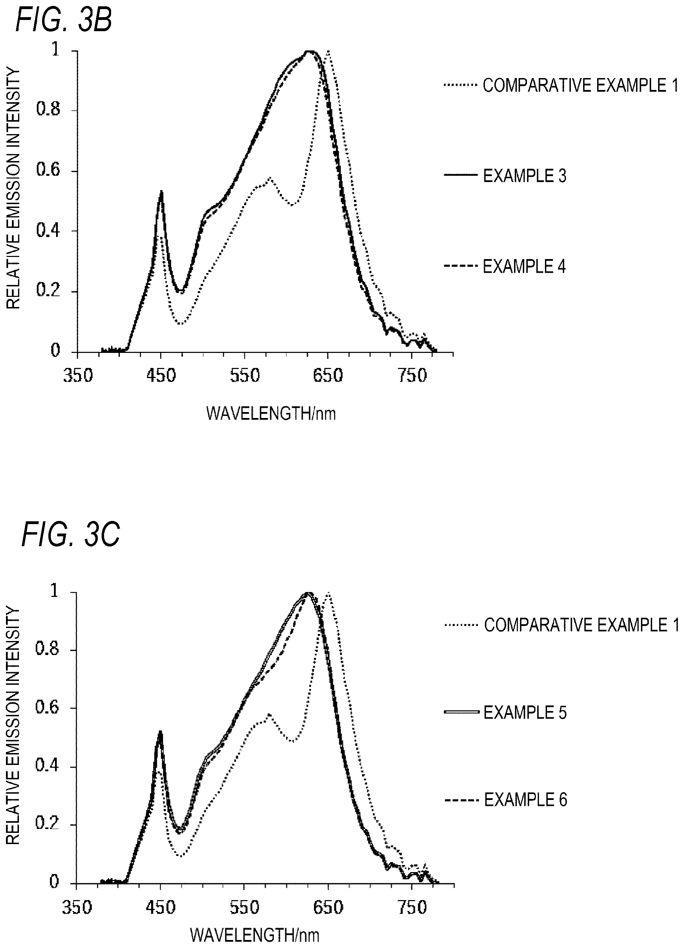

[Fig. 3B] Fig. 3B is a graph showing white spectra in Comparative Example 1, Example 3, and Example 4 at CIE chromaticity coordinates (0.437, 0.404) and a color temperature of 3000 K output from a simulation, which are normalized with setting a maximum emission intensity in a range of 480 nm to 780 nm to 1.

[Fig. 3C] Fig. 3C is a graph showing white spectra in Comparative Example 1, Example 5, and Example 6 at CIE chromaticity coordinates (0.437, 0.404) and a color temperature of 3000 K output from a simulation, which are normalized with setting a maximum emission intensity in a range of 480 nm to 780 nm to 1.

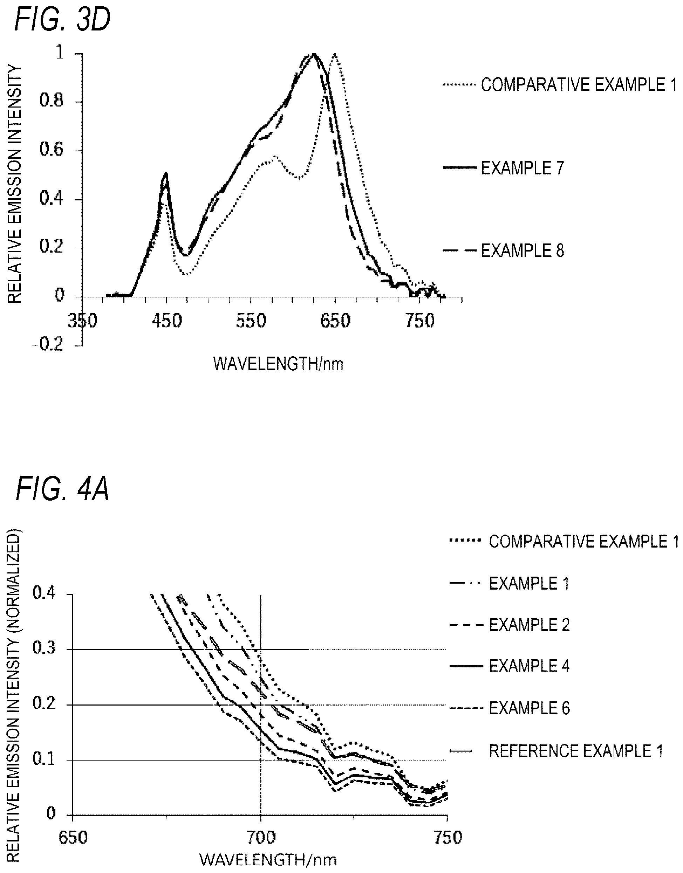

[Fig. 3D] Fig. 3D is a graph showing white spectra in Comparative Example 1, Example 7, and Example 8 at CIE chromaticity coordinates (0.437, 0.404) and a color temperature of 3000 K output from a simulation, which are normalized with setting a maximum emission intensity in a range of 480 nm to 780 nm to 1.

[Fig. 4A] Fig. 4A is a partially enlarged graph of the emission spectra in Comparative Example 1, Example 1, Example 2, Example 4, Example 6, and Reference Example 1 in Fig. 3A to Fig. 3D.

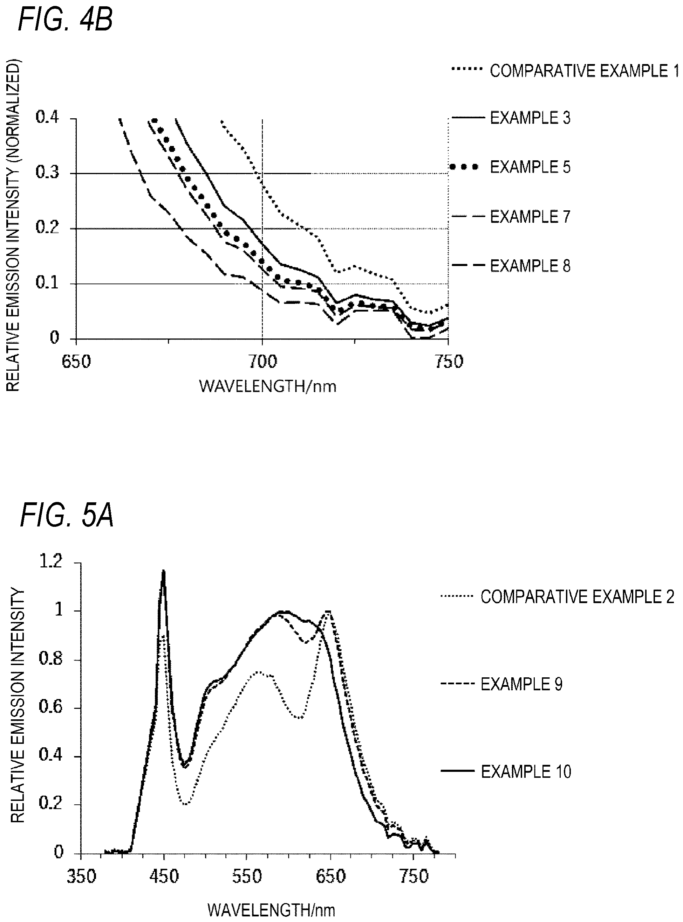

[Fig. 4B] Fig. 4B is a partially enlarged graph of the emission spectra in Comparative Example 1, Example 3, Example 5, Example 7, and Example 8 in Fig. 3B to Fig. 3D.

[Fig. 5A] Fig. 5A is a graph showing white spectra in Comparative Example 2, Example 9, and Example 10 at CIE chromaticity coordinates (0.380, 0.377) and a color temperature of 4000 K output from a simulation, which are normalized with setting a maximum emission intensity in a range of 480 nm to 780 nm to 1.

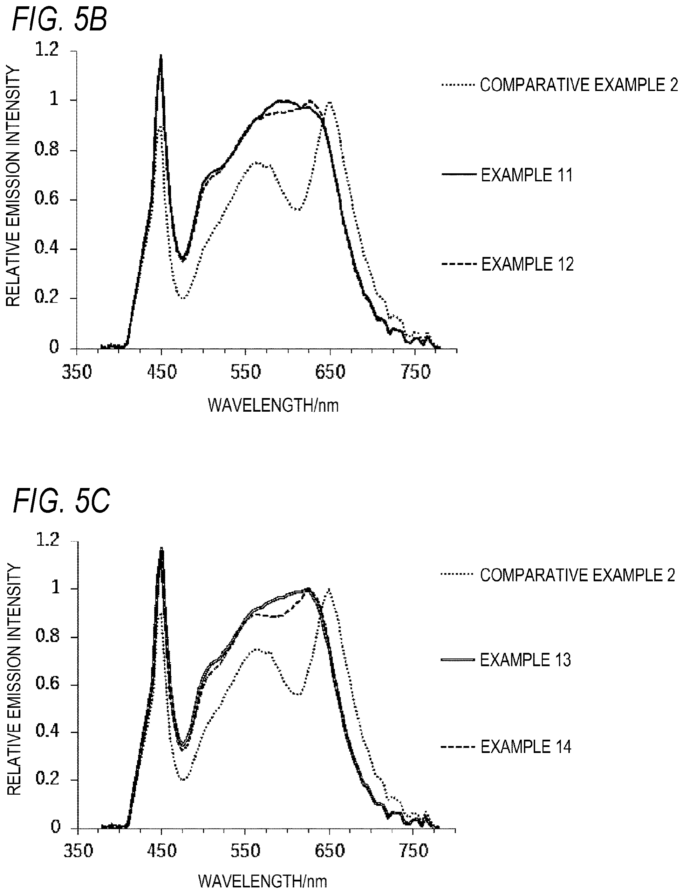

[Fig. 5B] Fig. 5B is a graph showing white spectra in Comparative Example 2, Example 11, and Example 12 at CIE chromaticity coordinates (0.380, 0.377) and a color temperature of 4000 K output from a simulation, which are normalized with setting a maximum emission intensity in a range of 480 nm to 780 nm to 1.

[Fig. 5C] Fig. 5C is a graph showing white spectra in Comparative Example 2, Example 13, and Example 14 at CIE chromaticity coordinates (0.380, 0.377) and a color temperature of 4000 K output from a simulation, which are normalized with setting a maximum emission intensity in a range of 480 nm to 780 nm to 1.

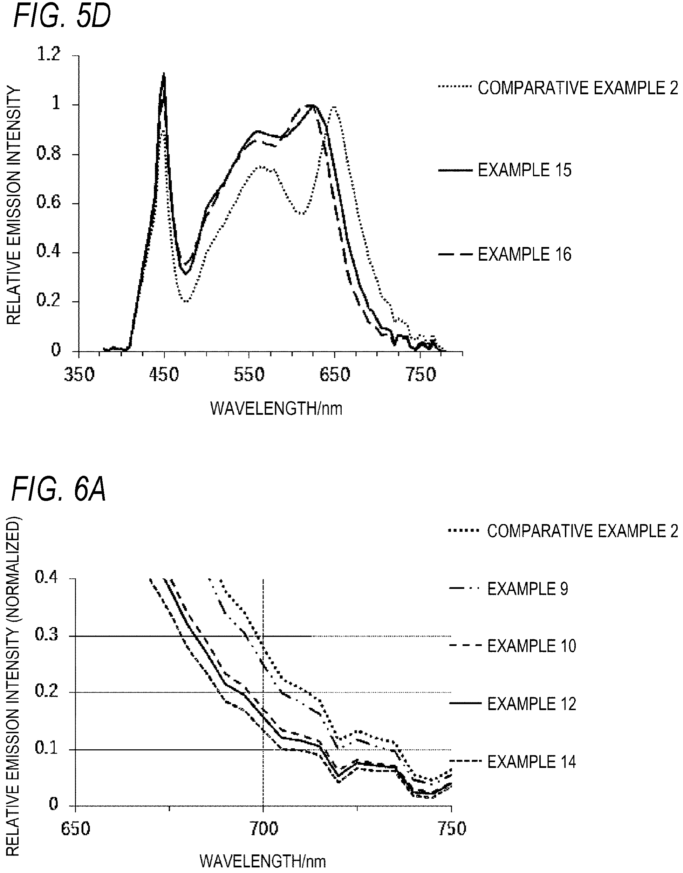

[Fig. 5D] Fig. 5D is a graph showing white spectra in Comparative Example 2, Example 15, and Example 16 at CIE chromaticity coordinates (0.380, 0.377) and a color temperature of 4000 K output from a simulation, which are normalized with setting a maximum emission intensity in a range of 480 nm to 780 nm to 1.

[Fig. 6A] Fig. 6A is a partially enlarged graph of the emission spectra in Comparative Example 2, Example 9, Example 10, Example 12, and Example 14 in Fig. 5A to Fig. 5D.

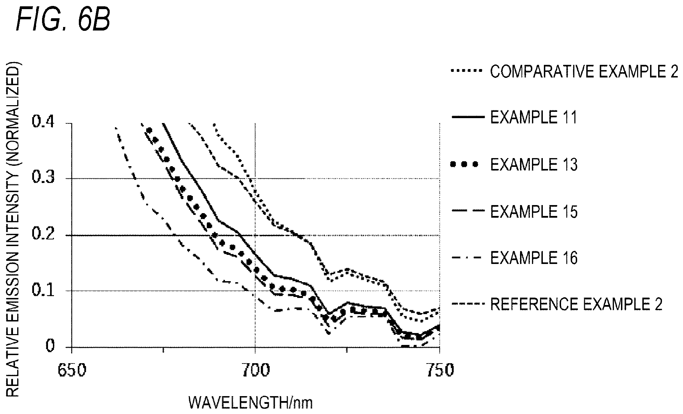

[Fig. 6B] Fig. 6B is a partially enlarged graph of the emission spectra in Comparative Example 2, Example 11, Example 13, Example 15, Example 16, and Reference Example 2 in Fig. 5B to Fig. 5D.

DESCRIPTION OF EMBODIMENTS

Hereinafter, the present invention will be explained by showing embodiments and examples, but the present invention is not limited to the following embodiments, examples, and the like, and can be implemented with any modifications within the scope of the gist of the present invention.

Note that in the present description, a numerical range expressed using "to" means a range which includes numerical values written before and after "to" as an upper limit value and a lower limit value. In addition, in a composition formula of a phosphor in the present description, the end of each composition formula is delimited by a comma (,). Further, when a plurality of elements are listed with delimiting by a comma (,), it indicates that one or two or more of the listed elements may be contained in any combination and composition. For example, a composition formula: "(Ca, Sr, Ba) $Al_2O_4$:Eu" comprehensively represents "$CaAl_2O_4$:Eu", "$SrAl_2O_4$:Eu", "$BaAl_2O_4$:Eu", "$Ca_{1-x}Sr_xAl_2O_4$:Eu", "$Sr_{1-x}Ba_xAl_2O_4$:Eu", "$Ca_{1-x}Ba_xAl_2O_4$:Eu", and "$Ca_{1-x-y}Sr_xBa_yAl_2O_4$:Eu" (where $0 < x < 1$, $0 < y < 1$, and $0 < x+y < 1$).

In one embodiment, the present invention provides a light-emitting device having at least one or more light emission colors having a correlated color temperature of 4000 K or lower, the light-emitting device including a light-emitting element including a first luminescent material and a second luminescent material which emits visible light by irradiation with light from the first luminescent material, in which the second luminescent material contains at least one or more phosphors having an emission peak in a wavelength region of 450 nm or more and less than 600 nm, and one or more other phosphors having an emission peak wavelength in a wavelength region of 600 nm or more and 700 nm or less, in at least one of the light emission colors having the correlated color temperature of 4000 K or lower, when an emission intensity at a wavelength $\lambda 1$ where an emission intensity of an emission spectrum is maximum at 600 nm or more and 700 nm or less is set to A, and an emission intensity at 700 nm is set to C, C/A is 0.25 or less, and the one or more other phosphors having the emission peak wavelength in the wavelength region of 600 nm or more and 700 nm or less include at least a phosphor containing a crystal phase having a composition represented by the following formula [1].

In another embodiment, the present invention provides a luminescent material having characteristics of the second luminescent material.

$$Re_xMA_aMB_bMC_cN_dX_e \qquad [1]$$

(In formula [1],
MA includes one or more elements selected from the group consisting of Sr, Ca, Ba, Na, K, Y, Gd, and La, MB includes one or more elements selected from the group consisting of Li, Mg, and Zn, MC includes one or more elements selected from the group consisting of Al, Si, Ga, In, and Sc, X includes one or more elements selected from the group consisting of F, Cl, Br, and I, Re includes one or more elements selected from the group consisting of Eu, Ce, Pr, Tb, and Dy, and a, b, c, d, e, and x respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2.)$$

The one or more other phosphors having the emission peak wavelength in the wavelength region of 600 nm or more and 700 nm or less may include at least a phosphor containing a crystal phase having a composition represented by the following formula [2].

$$Re_xMA_aMB_b(Al_{1-y}MC'_y)_cN_dX_e \qquad [2]$$

(In formula [2],
MA includes one or more elements selected from the group consisting of Sr, Ca, Ba, Na, K, Y, Gd, and La, MB includes one or more elements selected from the group consisting of Li, Mg, and Zn, MC' includes one or more elements selected from the group consisting of Si, Ga, In, and Sc, X includes one or more elements selected from the group consisting of F, Cl, Br, and I, Re includes one or more elements selected from the group consisting of Eu, Ce, Pr, Tb, and Dy, and a, b, c, d, e, x, and y respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \le 0.2$$

$$0.0 < y \le 1.0.)$$

In the above embodiment, when an emission intensity at 600 nm is set to B, B/A is 0.60 or more.

In one embodiment, the present invention provides a light-emitting device having at least one or more light emission colors having the correlated color temperature of 4000 K or lower, the light-emitting device including a light-emitting element including a first luminescent material and a second luminescent material which emits visible light by irradiation with light from the first luminescent material, in which the second luminescent material contains at least one or more phosphors having the emission peak in the wavelength region of 450 nm or more and less than 600 nm, and one or more other phosphors having an emission peak wavelength in a wavelength region of 600 nm or more and 700 nm or less, and in at least one of the light emission colors having the correlated color temperature of 4000 K or lower, when an emission intensity at a wavelength $\lambda 1$ where an emission intensity of an emission spectrum is maximum at 600 nm or more and 700 nm or less is set to A, an emission intensity at 600 nm is set to B, and an emission intensity at 700 nm is set to C, B/A is 0.60 or more and C/A is 0.20 or less.

In one embodiment, the light-emitting device has at least one or more light emission colors having the correlated color temperature of 4000 K or lower. The light-emitting device may be a device which emits only one color having the correlated color temperature of 4000 K or lower, or may have two or more light emission colors. In the case of having two or more light emission colors, a mechanism may be provided in which the light emission colors are changed continuously or discontinuously by using a control device.

When the B/A is 0.60 or more, it is possible to provide a light-emitting device having less unevenness in the spectrum and exhibiting an emission spectrum close to a sunlight spectrum. The B/A is preferably 0.70 or more, more preferably 0.75 or more, still more preferably 0.80 or more, and particularly preferably 0.90 or more, and is generally 1.00 or less.

The C/A is generally 0.25 or less, preferably 0.20 or less, more preferably 0.19 or less, still more preferably 0.18 or less, even more preferably 0.17 or less, and particularly preferably 0. 16 or less, and is generally 0.01 or more. When the C/A is equal to or less than the above upper limit, contribution of the wavelength region of low relative visibility is reduced, and a light-emitting device having excellent conversion efficiency can be provided.

In one embodiment, in the light-emitting device, in at least one of the light emission colors having the correlated color temperature of 4000 K or lower, when an emission intensity at a wavelength where the emission intensity of the emission spectrum is a local minimum in a wavelength region equal to or greater than an emission peak wavelength $\lambda 2$ of excitation light is set to D, a ratio D/A of the emission intensity D to the emission intensity A is 0.15 or more. When the value of the D/A is 0.15 or more, it is possible to provide a light-emitting device exhibiting an emission spectrum closer to the sunlight spectrum and showing high color rendering.

The D/A is preferably 0.17 or more, more preferably 0.20 or more, and is generally 0.9 or less.

In one embodiment, the light-emitting device is a light-emitting device in which in at least one of the light emission colors having the correlated color temperature of 4000 K or lower, the emission intensity of the emission spectrum continuously decreases from the wavelength $\lambda 1$ to 700 nm. When the emission spectrum satisfies the above characteristics, a spectrum shape is closer to that of sunlight, the color rendering is improved, the amount of components in the wavelength region of low relative visibility is reduced, and the conversion efficiency is improved.

In one embodiment, in the light-emitting device, a proportion of the one or more other phosphors having the emission peak wavelength in the wavelength region of 600 nm or more and 700 nm or less is 45 % by weight or less with respect to the second luminescent material. The proportion is preferably 40 % by weight or less, more preferably 30 % by weight or less, and still more preferably 25 % by weight or less. When the proportion is small, it is possible to implement a light emission color with a smaller amount of a phosphor, and it is possible to provide a light-emitting device having a high degree of freedom in design, such as reduction of the size of a light-emitting element.

In one embodiment, the light-emitting device is a light-emitting device including a plurality of light-emitting elements having different light emission colors or color temperatures, and a dimming device. By using such a device, it is possible to provide a light-emitting device capable of exhibiting two or more different light emission colors. That is, in one embodiment, the light-emitting device is a light-emitting device including a plurality of light-emitting elements having different light emission colors or color temperatures and a dimming device, and capable of exhibiting two or more mutually different light emission colors.

Existing ones can be used as the dimming device. For example, a control device which controls a voltage applied to different light-emitting elements, or a switch which individually controls on/off of power supply to each light-emitting element can be used.

In one embodiment, the one or more other phosphors having the emission peak wavelength in the wavelength region of 600 nm or more and 700 nm or less include a phosphor which does not substantially include Mn. In a specific embodiment, the one or more other phosphors having the emission peak wavelength in the wavelength region of 600 nm or more and 700 nm or less only consist of a phosphor which does not substantially include Mn. When a part of or the entire phosphor contained in the light-emitting device is a phosphor which does not substantially include Mn, a harmful Mn compound can be reduced in amount or excluded, and a light-emitting device which is good for the human body and the environment can be provided.

Note that in the present description, a phosphor which "does not substantially include" a specific component means a phosphor which does not contain the specific component as elements constituting a composition of a crystal phase of the phosphor, and to which the specific component is not added as an additive element, an activator, or the like. The phosphor which "does not substantially include" a specific component allows a trace amount of the specific component to be unintentionally mixed in as an impurity.

[Particle Size of Phosphor]

In one embodiment, the one or more other phosphors having the emission peak wavelength in the wavelength region of 600 nm or more and 700 nm or less include a phosphor whose particle size of the crystal phase is generally 2 $\mu$m or more and 40 $\mu$m or less in terms of a volume-based median particle size (volume median particle size), the lower limit value being preferably 3 $\mu$m, more preferably 4 $\mu$m, and still more preferably 5 $\mu$m, and the upper limit value being preferably 35 $\mu$m, more preferably 30 $\mu$m, still more preferably 25 $\mu$m, and particularly preferably 20 $\mu$m.

It is preferable that the volume-based median particle size (volume median particle size) is equal to or greater than the above lower limit from the viewpoint of improving light emission characteristics exhibited by the crystal phase in an LED package, and it is preferable that the volume-based median particle size (volume median particle size) is equal to or less than the above upper limit since clogging of nozzles in a production process for the LED package can be avoided by the crystal phase.

The volume-based median particle size (volume median particle size) of the crystal phase of the phosphor can be measured by measurement techniques well known to those skilled in the art, and can be measured, for example, by a laser granulometer in a preferred embodiment. In Examples in the present description, the volume-based median particle size (volume median particle size, $d_{50}$) is defined as a particle size at which the volume-based relative particle amount is 50% when a sample is measured using a particle size distribution analyzer based on the principle of laser diffraction/scattering, and the particle size distribution (cumulative distribution) is determined.

{Physical properties, and the like of Phosphor}

[Space Group]

In one embodiment, the one or more other phosphors having the emission peak wavelength in the wavelength region of 600 nm or more and 700 nm or less are not limited as long as the effects of the present invention are obtained, and a phosphor whose crystal system (space group) is P-1 is included in a specific embodiment. The space group in the phosphor according to the present embodiment is not particularly limited if an average structure statistically considered within a distinguishable range by powder X-ray diffraction or single crystal X-ray diffraction shows a repeating period having the above length, and preferably belongs to No. 2 based on "International Tables for Crystallography (Third, revised edition), Volume A SPACE-GROUP SYMMETRY".

By being in the above space group, a phosphor having a narrow full width at half maximum (FWHM) in the emission spectrum and favorable emission efficiency can be obtained.

Here, the space group can be determined according to a well-known method, for example, by electron beam diffraction, X-ray diffraction structure analysis using a powder or a single crystal, and neutron beam diffraction structure analysis.

[Internal Quantum Efficiency of Phosphor]

In one embodiment, the one or more other phosphors having the emission peak wavelength in the wavelength region of 600 nm or more and 700 nm or less have internal quantum efficiency of 30% or more. The internal quantum efficiency is preferably 35% or more, more preferably 40% or more, still more preferably 45% or more, particularly preferably 50% or more, and especially preferably 55% or more. The upper limit thereof is not limited and is preferably higher, and it is generally 100%. The quantum efficiency can be determined by a well-known method, and can be calculated from, for example, an emission spectrum measured using a spectrophotometer

[Characteristics of Emission Spectrum]

In one embodiment, the one or more other phosphors having the emission peak wavelength in the wavelength region of 600 nm or more and 700 nm or less include a phosphor which is excited by irradiation with light having an appropriate wavelength, and which emits red light exhibiting a favorable emission peak wavelength in the emission spectrum and a favorable full width at half maximum (FWHM) in the emission spectrum. Hereinafter, the emission spectrum, the excitation wavelength, the emission peak wavelength, and the full width at half maximum (FWHM) in the emission spectrum will be described.

(Excitation Wavelength)

In one embodiment, the one or more other phosphors having the emission peak wavelength in the wavelength region of 600 nm or more and 700 nm or less have an excitation peak in a wavelength range of generally 270 nm or more, preferably 300 nm or more, more preferably 320 nm or more, still more preferably 350 nm or more, and particularly preferably 400 nm or more, and of generally 550 nm or less, preferably 520 nm or less, and more preferably 500 nm or less. That is, a phosphor excited by light in a near-ultraviolet to a blue region is included.
Note that the description of the shape of the emission spectrum, and the emission peak wavelength and the full width at half maximum below are applicable regardless of the excitation wavelength. From the viewpoint of improving the quantum efficiency, it is preferable to emit light having a wavelength in the above range with favorable absorption and excitation efficiency.

(Emission Peak Wavelength)

In one embodiment, in the one or more other phosphors having the emission peak wavelength in the wavelength region of 600 nm or more and 700 nm or less, the emission spectrum has at least one emission peak having an emission peak wavelength of generally 610 nm or more and 660 nm or less.
In another specific embodiment, the one or more other phosphors having the emission peak wavelength in the wavelength region of 600 nm or more and 700 nm or less include at least one phosphor exhibiting an emission peak wavelength in a wavelength region of preferably 655 nm or less, more preferably 650 nm or less, still more preferably 648 nm or less, even more preferably 645 nm or less, particularly preferably 640 nm or less, and extremely preferably 637 nm or less. In addition, the emission peak wavelength of the phosphor is preferably 610 nm or more, and more preferably 620 nm or more. In a specific embodiment, the one or more other phosphors having the emission peak wavelength in the wavelength region of 600 nm or more and 700 nm or less include at least one phosphor which exhibits an emission peak wavelength in a wavelength region of 600 nm or more and 648 nm or less.
A light-emitting device containing a phosphor having at least one emission peak whose emission peak wavelength is equal to or less than the above upper limit has a low emission intensity in a wavelength region around 700 nm, where the relative visibility is low, and has a favorable conversion efficiency.
In addition, when the emission peak wavelength is equal to or greater than the above lower limit, it is possible to obtain favorable light emission in a red region, and it is possible to obtain a light-emitting device having favorable red color rendering or red color reproducibility, which is thus suitable for applications such as a backlight for an image display device (display).
The method of adjusting the emission peak wavelength is not particularly limited. For example, by adjusting the configuration of the MC element, the emission peak wavelength can be adjusted with keeping the full width at half maximum in the emission spectrum narrow. In a specific embodiment, the emission peak wavelength can be adjusted to a short wavelength side by increasing the proportion of MC.

<Full Width at Half Maximum in Emission Spectrum>

In one embodiment, the one or more other phosphors having the emission peak wavelength in the wavelength region of 600 nm or more and 700 nm or less include a phosphor having a full width at half maximum in the emission spectrum of generally 70 nm or less, preferably 65 nm or less, more preferably 60 nm or less, still more preferably 57 nm or less, particularly preferably 55 nm or less, and most preferably 50 nm or less, and of generally 10 nm or more, preferably 20 nm or more, more preferably 25 nm or more, and still more preferably 30 nm or more.
When a phosphor having a full width at half maximum in the emission spectrum within the above range is used, a color reproduction range can be widened without reducing a color purity in an image display device such as a liquid crystal display.
In addition, when the emission peak wavelength and the full width at half maximum in the emission spectrum are equal to or less than the above upper limits, a phosphor having relatively high visibility in the emission wavelength region can be provided, and when such a phosphor is used in a light-emitting device, a light-emitting device having high conversion efficiency can be provided.

Note that in order to excite the phosphor with light having a wavelength of about 450 nm, a GaN-based LED can be used, for example. In addition, measurement of the emission spectrum, and calculation of the emission peak wavelength, the peak relative intensity, and the full width at half maximum in the emission spectrum of the phosphor can be performed using, for example, a commercially available spectrum measuring device, such as a phosphorescence measuring device equipped with a light source having an emission wavelength of 300 nm to 400 nm, such as a commercially available xenon lamp, and a general photodetector.

In one embodiment, in the light-emitting device, among the one or more other phosphors having the emission peak wavelength in the wavelength region of 600 nm or more and 700 nm or less, a phosphor having an emission peak wavelength x (nm) and a full width at half maximum y (nm) in the emission spectrum satisfying a relationship $y \leq 184-0.2x$ is included.

When a phosphor having the emission peak wavelength and the full width at half maximum of the phosphor satisfying the above expression is used, the conversion efficiency of the light-emitting device can be improved.

<Phosphor>

A phosphor used in the light-emitting device according to the present embodiment is not particularly limited as long as the characteristics of the light-emitting device are not lost, and examples for implementing the invention will be given.

That is, in one embodiment, the one or more other phosphors having the emission peak wavelength in the wavelength region of 600 nm or more and 700 nm or less include at least a phosphor containing a crystal phase having a composition represented by the following formula [1].

$$Re_xMA_aMB_bMC_cN_dX_e \qquad [1]$$

(In formula [1],
MA includes one or more elements selected from the group consisting of Sr, Ca, Ba, Na, K, Y, Gd, and La, MB includes one or more elements selected from the group consisting of Li, Mg, and Zn, MC includes one or more elements selected from the group consisting of Al, Si, Ga, In, and Sc, X includes one or more elements selected from the group consisting of F, Cl, Br, and I, Re includes one or more elements selected from the group consisting of Eu, Ce, Pr, Tb, and Dy, and a, b, c, d, e, and x respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2.)$$

In one embodiment, the one or more other phosphors having the emission peak wavelength in the wavelength region of 600 nm or more and 700 nm or less include at least a phosphor containing a crystal phase having a composition represented by the following formula [2].

$$Re_xMA_aMB_b(Al_{1-y}MC'_y)_cN_dX_e \qquad [2]$$

(In formula [2], MA includes one or more elements selected from the group consisting of Sr, Ca, Ba, Na, K, Y, Gd, and La, MB includes one or more elements selected from the group consisting of Li, Mg, and Zn, MC' includes one or more elements selected from the group consisting of Si, Ga, In, and Sc, X includes one or more elements selected from the group consisting of F, Cl, Br, and I, Re includes one or more elements selected from the group consisting of Eu, Ce, Pr, Tb, and Dy, and a, b, c, d, e, x, and y respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2$$

$$0.0 < y \leq 1.0.)$$

In formula [1] or [2], as Re, europium (Eu), cerium (Ce), praseodymium (Pr), neodymium (Nd), samarium (Sm), terbium (Tb), dysprosium (Dy), holmium (Ho), erbium (Er), thulium (Tm), ytterbium (Yb) or the like can be used. From the viewpoint of improving the emission wavelength and the emission quantum efficiency, Re preferably includes one or more elements selected from the group consisting of Eu, Ce, Pr, Tb, and Dy, and more preferably includes Eu. Still more preferably, 80 mol% or more of Re is Eu, and even more preferably, Re is Eu.

In formula [1] or [2], MA includes one or more elements selected from the group consisting of calcium (Ca), strontium (Sr), barium (Ba), sodium (Na), potassium (K), yttrium (Y), gadolinium (Gd), and lanthanum (La), preferably includes one or more elements selected from the group consisting of Ca, Sr, and Ba, and more preferably MA includes Sr. Preferably, 80 mol% or more of MA consists of the above preferred elements, and more preferably, MA consists of the above preferred elements.

In formula [1] or [2], MB includes one or more elements selected from the group consisting of lithium (Li), magnesium (Mg), and zinc (Zn), and preferably includes Li. More preferably, 80 mol% or more of MB is Li, and still more preferably, MB is Li.

In formula [1], MC includes one or more elements selected from the group consisting of aluminum (Al), silicon (Si), gallium (Ga), indium (In), and scandium (Sc), preferably includes Al, Ga, or Si, and more preferably includes Al or Ga. Still more preferably, 80 mol% or more of MC consists of one or more elements of Al and Ga, particularly preferably, 90 mol% or more of MC consists of one or more elements of Al and Ga, and most preferably, MC consists of one or more elements of Al and Ga.

With the above configuration, the full width at half maximum of the phosphor can be kept narrow, the emission peak wavelength can be set to 620 nm to 660 nm, and a light-emitting device having excellent conversion efficiency can be provided.

In formula [2], MC' includes one or more elements selected from the group consisting of silicon (Si), gallium (Ga), indium (In), and scandium (Sc), preferably includes Ga or Si, and more preferably includes Ga. Still more preferably, 80 mol% or more of MC' consists of Ga, particularly preferably, 90 mol% or more of MC' consists of Ga, and most preferably, MC' consists of Ga.

With the above configuration, the emission wavelength of the phosphor can be set to 648 nm, and a light-emitting device having excellent conversion efficiency can be provided.

In formula [1] or [2], N represents nitrogen. In order to maintain charge balance of the entire crystal phase or to adjust the emission peak wavelength, a part of N may be substituted with oxygen (O).

In formula [1] or [2], X includes one or more elements selected from the group consisting of fluorine (F), chlorine (Cl), bromine (Br), and iodine (I). That is, in a specific embodiment, from the viewpoint of stabilizing a crystal structure and maintaining the charge balance of the phosphor as a whole, N may be partially substituted with the halogen element represented by X.

In formula [1] or [2], a case where trace amounts of components other than those specified are unavoidably or unintentionally contained is included.

Examples of the components other than those specified include an element whose element number differs by one from the artificially added element, a homologous element of the artificially added element, an artificially added rare earth element and another rare earth element, a halogen element when using halides as Re raw materials, and other elements which can generally be contained as impurities in various raw materials.

In the present description, "artificially adding" a specific component means intentionally adding a specific component as an element constituting a composition of a crystal phase of a phosphor, and a case where a trace amount of a specific component is unintentionally mixed in as an impurity and the like does not fall under the category of "artificially adding". A phosphor to which a specific component is artificially added can be said to substantially include the specific component.

Components other than those specified may be unavoidably or unintentionally contained, for example, when derived from impurities in raw materials, or when introduced during production processes such as a pulverization step and a synthesis step. In addition, examples of the components added in a trace amount include a reaction aid and Re raw materials.

In formula [1] or [2], a, b, c, d, e, x, and y indicate molar contents of MA, MB, MC, N, X, Re, and MC' contained in the phosphor, respectively.

The value of a is generally 0.6 or more, preferably 0.7 or more, more preferably 0.8 or more, and still more preferably 0.9 or more, and is generally 1.4 or less, preferably 1.3 or less, more preferably 1.2 or less, and still more preferably 1.1 or less.

The value of b is generally 0.6 or more, preferably 0.7 or more, more preferably 0.8 or more, and still more preferably 0.9 or more, and is generally 1.4 or less, preferably 1.3 or less, more preferably 1.2 or less, and still more preferably 1.1 or less.

The value of c is generally 2.1 or more, preferably 2.4 or more, more preferably 2.6 or more, and still more preferably 2.8 or more, and is generally 3.9 or less, preferably 3.6 or less, more preferably 3.4 or less, and still more preferably 3.2 or less.

The value of d is generally 3 or more, preferably 3.2 or more, more preferably 3.4 or more, still more preferably 3.6 or more, and even more preferably 3.8 or more, and is generally 5 or less, preferably 4.8 or less, more preferably 4.6 or less, still more preferably 4.4 or less, and even more preferably 4.2 or less.

The value of e is not particularly limited and is generally 0 or more, generally 0.2 or less, preferably 0.1 or less, more preferably 0.06 or less, still more preferably 0.04 or less, and even more preferably 0.02 or less.

When b, c, d, and e are within the above ranges, the crystal structure is stabilized. In addition, the values of d and e can be appropriately adjusted for the purpose of maintaining the charge balance of the entire phosphor.

When the value of a is within the above range, the crystal structure is stabilized and a phosphor with few heterogeneous phases can be obtained. When such a red phosphor is contained, it is possible to provide a light-emitting device having favorable absorption efficiency for excitation light, a favorable red color and overall conversion efficiency.

The value of b+c is generally 3.1 or more, preferably 3.4 or more, and more preferably 3.7 or more, and is generally 4.9 or less, preferably 4.6 or less, and more preferably 4.3 or less.

When the value of b+c is within the above range, the crystal structure is stabilized.

The value of d+e is generally 3.2 or more, preferably 3.4 or more, and more preferably 3.7 or more, and is generally 5.0 or less, preferably 4.6 or less, and more preferably 4.3 or less.

When the value of d+e is within the above range, the crystal structure is stabilized.

When all values are in the above-noted ranges, the resulting phosphor has a favorable emission peak wavelength and full width at half maximum in an emission spectrum, which is preferred.

The value of x is generally greater than 0, preferably 0.0001 or more, and more preferably 0.001 or more, and is generally 0.2 or less, preferably 0.15 or less, more preferably 0.12 or less, still more preferably 0.1 or less, and even more preferably 0.08 or less. When the value of x is a value equal to or greater than the above lower limit or greater than the above lower limit, it is possible to obtain a phosphor having a favorable emission intensity, and when the value of x is equal to or less than the above upper limit, it is possible to obtain a phosphor which has Re favorably incorporated into the crystal and easily functions as an emission center. When such phosphor is contained, a light-emitting device having favorable conversion efficiency can be provided.

The value of y is greater than 0.0, generally 0.01 or more, preferably 0.015 or more, more preferably 0.03 or more, still more preferably 0.05 or more, and particularly preferably 0.10 or more, and is generally 1.00 or less, preferably 0.70 or less, more preferably 0.50 or less, still more preferably 0.30 or less, and particularly preferably 0.25 or less.

When the value of y is equal to or greater than the above lower limit, the emission peak wavelength of the phosphor is shorter, and when such a phosphor is used, a light-emitting device having favorable color rendering or color reproducibility can be provided. In addition, when the value of y is equal to or less than the above upper limit, a phosphor having a favorable emission intensity can be obtained, and when such a phosphor is used, a light-emitting device having favorable conversion efficiency can be provided. In order to obtain a preferred emission intensity and emission peak wavelength depending on the purpose, the value of y can be adjusted as appropriate.

Note that a method of specifying an elemental composition of the phosphor is not particularly limited, and can be found with a routine method. For example, specification can be performed with GD-MS, ICP spectroscopy, an energy-dispersive X-ray spectrometer (EDX), or the like.

{Method for Producing Phosphor}A method for obtaining a phosphor containing a crystal phase having a composition represented by above formula [1] or [2], which is used in the light-emitting device according to a specific embodiment, will be exemplified.

The phosphor according to the present embodiment can be synthesized by mixing raw materials of respective elements constituting the phosphor such that the proportions of respective elements satisfy formula [1] or [2], followed by heating.

[Raw Material]

The raw material of each element (MA, MB, MC, MC', MD, and Re) are not particularly limited, and examples may include the element alone, an oxide, a nitride, a hydroxide, a halide such as a chloride or a fluoride, an inorganic salt such as sulfate, nitrate, or phosphate, an organic salt such as acetate, and the like. In addition, a compound containing two or more in the above element group may be used. In addition, each compound may be a hydrate or the like.

The method of obtaining each raw material is not particularly limited, and commercially available materials can be purchased and used.

The purity of each raw material is not particularly limited, and is preferably high from the viewpoint of a strict element ratio and from the viewpoint of avoiding the appearance of heterogeneous phases due to impurities. The purity is generally 90 mol% or more, preferably 95 mol% or more, more preferably 97 mol% or more, and still more preferably 99 mol% or more. The upper limit thereof is not particularly limited, and is generally 100 mol%, and unavoidable impurities may be contained.

In Examples to be described below, in all cases, a raw material having a purity of 95 mol% or more was used.

The oxygen element (O), nitrogen element (N), and halogen element (X) can be supplied using an oxide, nitride, and halide or the like as the raw material for each of the elements, but can also be introduced by using an oxygen- or nitrogen-containing atmosphere during a synthesis reaction.

[Mixing Step]

The method of mixing the raw materials is not particularly limited, and a well-known method can be used. For example, raw materials are weighed so as to obtain a desired composition, and sufficiently mixed using a ball mill or the like to obtain a raw material mixture. The above mixing method is not particularly limited, and specific examples include the following methods (a) and (b).

(a) A dry mixing method of pulverizing and mixing the raw materials by combining pulverization using, for example, a dry pulverizer such as such as a hammer mill, a roll mill, a ball mill, and a jet mill, or a mortar and a pestle with mixing using, for example, a mixer such as a ribbon blender, a V type blender, and a Henschel mixer, or a mortar and a pestle.
(b) A wet mixing method of adding a solvent or a dispersion medium such as water to the raw materials, performing mixing using, for example, a pulverizer, a mortar and a pestle, or an evaporating dish and a stirring rod to bring the mixture to a solution or slurry state, and then performing drying by spray drying, heat drying, or natural drying.

The raw materials may be mixed by either the dry mixing method or the wet mixing method. In order to avoid contamination of the raw materials with moisture, a dry mixing method or a wet mixing method using a water-insoluble solvent is preferred.

Note that in Examples to be described below, the method (a) was used.

[Heating Step]

In the heating step, for example, the raw material mixture obtained in the mixing step is charged into a crucible, and subsequently heated at a temperature of from 500°C to 1200°C, preferably from 600°C to 1000°C, and more preferably from 650°C to 950°C.

When the heating temperature is made to be a low temperature, particularly 950°C or lower, a phosphor having a composition represented by formula [1] or [2] with a high phase purity and a high emission intensity can be obtained. The reason is that at a high temperature such as 1000°C or higher or 1100°C or higher, substances containing Li, Mg, Na, etc. with a high vapor pressure tend to volatilize, and a ratio of each element in the synthesis reaction for the phosphor tends to fluctuate, and on the other hand, by performing synthesis at a low temperature such as 950°C or lower, there is a possibility that the fluctuation in the ratio of each element can be prevented.

In addition, a pressure in the heating step may be a normal pressure or pressurization may be performed as long as the desired phosphor is obtained, and pressurization is preferred in order to prevent volatilization of the raw material elements. In the case of pressurization, the pressure is generally 0.1 MPa or more and 200 MPa or less, preferably 100 MPa or less, and more preferably 50 MPa or less. When the pressure is within the above range, favorable reactivity of the raw materials can be ensured.

The pressurization method is not limited, and for example, a method of heating a sealed container, a mechanical pressurization method, or a method of using a gas pressure can be used.

The material of the crucible is preferably one which does not react with the raw materials or reactants, and examples thereof include ceramics such as alumina, quartz, boron nitride, silicon carbide, and silicon nitride, metals such as nickel, platinum, molybdenum, tungsten, tantalum, niobium, iridium, and rhodium, or an alloy containing these as a main component.

The heating is preferably performed under an inert atmosphere, and a gas containing nitrogen, argon, helium, or the like as a main component can be used.

Note that in Examples to be described below, the heating was performed under a nitrogen atmosphere.

In the heating step, the heating is performed in the above temperature range for generally from 10 minutes to 200 hours, preferably from 1 hour to 100 hours, more preferably from 2 hours to 50 hours, and still more preferably from 3 hours to 25 hours. In addition, this heating step may be performed once, or may be performed a plurality of times. Examples of an aspect in which the heating step is performed a plurality of times include an aspect including an annealing step of performing heating under a pressure to repair defects, and an aspect of primary heating for obtaining primary particles or intermediates and then performing secondary heating for obtaining secondary particles or a final product.

[Post-treatment Step]

The obtained phosphor may be subjected to post-treatments such as classification and washing using well-known methods.

For example, by the above method, a phosphor satisfying the above formula [1] or [2] can be obtained.

<Light-emitting Device>

In a light-emitting device according to the present embodiment, the one or more phosphors having an emission peak in a wavelength region of 450 nm or more and less than 600 nm include any one or more of a garnet type phosphor, a silicate type phosphor, a nitride phosphor, and an oxynitride phosphor.

Specifically, in a case of configuring the light-emitting device, a yellow phosphor having an emission peak in a wavelength range of 550 nm or more and less than 600 nm, and a green phosphor having an emission peak in a wavelength range of 500 nm or more and 560 nm or less may be included.

When the phosphors in the above wavelength regions are appropriately combined, a light-emitting device exhibiting excellent color reproducibility can be provided. Note that as for an excitation light source, one having an emission peak in a wavelength range of less than 420 nm may be used.

Hereinafter, an aspect of a light-emitting device when using the one or more phosphors having the emission peak in the wavelength region of 450 nm or more and less than 600 nm will be described as an example of a specific embodiment, but the present embodiment is not limited thereto.

In the above case, the light-emitting device according to the present embodiment can be, for example, the following (X), (Y) or (Z) aspects.

(X) An aspect in which at least one phosphor (yellow phosphor) having an emission peak in a wavelength range of 550 nm or more and less than 600 nm and one or more other phosphors having the emission peak wavelength in the wavelength region of 600 nm or more and 700 nm or less are used as the second luminescent material.

(Y) An aspect in which at least one phosphor (green phosphor) having an emission peak in a wavelength range of 500 nm or more and 560 nm or less and one or more other phosphors having the emission peak wavelength in the wavelength region of 600 nm or more and 700 nm or less are used as the second luminescent material.

(Z) An aspect in which at least one phosphor (yellow phosphor) having an emission peak in a wavelength range of 550 nm or more and less than 600 nm, at least one phosphor (green phosphor) having an emission peak in a wavelength range of 500 nm or more and 560 nm or less, and one or more other phosphors having the emission peak wavelength in the wavelength region of 600 nm or more and 700 nm or less are used as the second luminescent material.

As the yellow phosphor and/or the green phosphor in the above aspects, commercially available ones can be used. For example, a garnet type phosphor, a silicate type phosphor, a nitride phosphor, an oxynitride phosphor, and the like can be used. In a specific embodiment, the yellow phosphor and/or the green phosphor include one or more of a garnet type phosphor, a silicate type phosphor, a nitride phosphor, and an oxynitride phosphor.

<Yellow Phosphor>

Examples of the garnet type phosphor which can be used in the yellow phosphor include $(Y, Gd, Lu, Tb, La)_3(Al, Ga)_5O_{12}$:(Ce, Eu, Nd). Examples of the silicate type phosphor which can be used in the yellow phosphor include $(Ba, Sr, Ca, Mg)_2SiO_4$:(Eu, Ce). Examples of the nitride phosphor and the oxynitride phosphor which can be used in the yellow phosphor include $(Ba, Ca, Mg)Si_2O_2N_2$:Eu (SION-based phosphor), $(Li, Ca)_2(Si, Al)_{12}(O, N)_{16}$:(Ce, Eu) (a-sialon phosphor), $(Ca, Sr)AlSi_4(O, N)_7$:(Ce, Eu) (1147 phosphor), and $(La, Ca, Y, Gd)_3(Al, Si)_6N_{11}$:(Ce, Eu) (LSN phosphor).

These may be used alone or in combination of two or more kinds thereof.

Among the above phosphors, the yellow phosphor is preferably a garnet type phosphor, and most preferably a YAG-based phosphor represented by $Y_3Al_5O_{12}$:Ce.

<Green Phosphor>

Examples of the garnet-based phosphor which can be used in the green phosphor include $(Y, Gd, Lu, Tb, La)_3(Al, Ga)_5O_{12}$:(Ce, Eu, Nd) and $Ca_3(Sc, Mg)_2Si_3O_{12}$:(Ce, Eu) (CSMS phosphor). Examples of the silicate-based phosphor which can be used in the green phosphor include $(Ba, Sr, Ca, Mg)_3SiO_{10}$:(Eu, Ce) and $(Ba, Sr, Ca, Mg)_2SiO_4$:(Ce, Eu) (BSS phosphor). Examples of the oxide phosphor which can be used in the green phosphor include $(Ca, Sr, Ba, Mg)(Sc, Zn)_2O_4$:(Ce, Eu) (CASO phosphor). Examples of the nitride phosphor and the oxynitride phosphor which can be used in the green phosphor include $(Ba, Sr, Ca, Mg)Si_2O_2N_2$:(Eu, Ce), $Si_{6-z}Al_zO_zN_{8-z}$:(Eu, Ce) (β-sialon phosphor) $(0 < z \leq 1)$, $(Ba, Sr, Ca, Mg, La)_3(Si, Al)_6O_{12}N_2$:(Eu, Ce) (BSON phosphor), and $(La, Ca, Y, Gd)_3(Al, Si)_6N_{11}$:(Ce, Eu) (LSN phosphor).

These may be used alone or in combination of two or more kinds thereof.

<Red Phosphor>

As a red phosphor, the phosphor according to the present embodiment having the emission peak wavelength in the wavelength region of 600 nm or more and 700 nm or less is used. In addition to the phosphor according to the present embodiment, other orange through red phosphors can be used, for example, a garnet type phosphor, a sulfide phosphor, a nanoparticle phosphor, a nitride phosphor, and an oxynitride phosphor can be used. As an other orange through red phosphors, for example, the following phosphors can be used.

Examples of the sulfide phosphor include $(Sr, Ca)S$:Eu (CAS phosphor) and $La_2O_2S$:Eu (LOS phosphor). Examples of the garnet type phosphor include $(Y, Lu, Gd, Tb)_3Mg_2AlSi_2O_{12}$:Ce. Examples of the nanoparticle phosphor include CdSe. Examples of the nitride or oxynitride phosphor include $(Sr, Ca)AlSiN_3$:Eu (S/CASN phosphor), $(CaAlSiN_3)_{1-x}\cdot(SiO_2N_2)_x$:Eu (CASON phosphor), $(La, Ca)_3(Al, Si)_6N_{11}$:Eu (LSN phosphor), $(Ca, Sr, Ba)_2Si_5(N, O)_8$:Eu (258 phosphor), $(Sr, Ca)Al_{1+x}Si_{4-x}O_xN_{7-x}$:Eu (1147 phosphor), $M_x(Si, Al)_{12}(O, N)_{16}$:Eu (M is Ca, Sr, or the like) (α-sialon phosphor), and $Li(Sr, Ba)Al_3N_4$:Eu (all x above is 0 < x < 1).

These may be used alone or in combination of two or more kinds thereof.

[Configuration of Light-emitting Device]

The light-emitting device according to the present embodiment includes a first luminescent material (excitation light source), and as a second luminescent material, a luminescent material containing at least one or more phosphors having the emission peak in the wavelength region of 450 nm or more and less than 600 nm and one or more other phosphors having the emission peak wavelength in the wavelength region of 600 nm or more and 700 nm or less is used. A configuration of the light-emitting device is not limited, and any known device configuration can be used.

As the first luminescent material, an LED element having a light-emitting structure made of various semiconductors such as a GaN-based semiconductor, a ZnO-based semiconductor, and a SiC-based semiconductor can be used.

Examples of the device configuration and embodiments of the light-emitting device include those described in JP2007-291352A, for example.

In addition, the LED element may be fixed in a package such as a cannonball-type package or an SMD-type package, or directly fixed on a circuit board as in the case of a chip-on-board type light-emitting device. The form of optical coupling between the LED element and the phosphor is not particularly limited, and a space therebetween may simply be filled with a transparent medium (including air), or an optical element such as a lens, an optical fiber, a light guide plate, or a reflecting mirror may be interposed therebetween. A structure in which phosphor particles are dispersed in a translucent matrix is typically formed by curing a resin paste in which particulate phosphors are dispersed. In addition to a structure in which such a cured product of paste is embedded into an LED element, various structures can be used, such as a structure in which such a cured product covers a part of the surface of the LED element in a film form, and a structure in which a film made of such a cured product is disposed at a location away from the LED element.

{Application of Light-emitting Device}

Applications of the light-emitting device are not particularly limited, and the light-emitting device can be used in various fields where a general light-emitting device is used. A light-emitting device having high color rendering can be particularly suitably used as a light source for an illumination device or an image display device.

In addition, a light-emitting device containing a red phosphor having a favorable emission wavelength can also be used in a red indicator lamp for a vehicle, or in a white light indicator lamp for a vehicle which includes the red color.

[Illumination Device]

In one embodiment, the present invention can provide an illumination device including the light-emitting device as a light source.

When the light-emitting device is applied to an illumination device, a specific configuration of the illumination device is not limited, and a light-emitting device such as those described above may be appropriately incorporated into a known illumination device and used. Examples thereof include a plane emission illumination device in which many light-emitting devices are lined up on a bottom surface of a holding case.

[Image Display Device]

In one embodiment, the present invention can provide an image display device including the light-emitting device as a light source.

When the light-emitting device is used as a light source of an image display device, the specific configuration of the image display device is not limited, and use together with a color filter is preferred. For example, in a case of forming a color image display device using a color liquid crystal display element as the image display device, an image display device can be formed by setting the light-emitting device as a back light, and combining an optical shutter using a liquid crystal with a color filter having red, green, and blue pixels.

[Indicator Lamp for Vehicle]

In one embodiment, the present invention can provide an indicator lamp for a vehicle including the light-emitting device as a light source.

In a specific embodiment, a light-emitting device used in an indicator lamp for a vehicle is preferably a light-emitting device radiating white light. In the light-emitting device radiating white light, light radiated from the light-emitting device preferably has a deviation duv (also known as "Δuv") from the blackbody radiation locus of a light color of -0.0200 to 0.0200 and a correlated color temperature of 5000 K or higher and 30000 K or lower.

In a specific embodiment, a light-emitting device used in an indicator lamp for a vehicle is preferably a light-emitting device radiating red light. In this embodiment, for example, the light-emitting device may absorb blue light emitted from a blue LED chip and emit red color to form a red light indicator lamp for a vehicle.

The indicator lamp for a vehicle includes illumination provided to a vehicle for the purpose of providing another vehicle, a person, or the like with some sort of indication, such as a head lamp, a side lamp, a back lamp, a blinker, a brake lamp, or a fog lamp of a vehicle.

Examples

Hereinafter, some specific embodiments of the present invention will be described with reference to Examples, but the present invention is not limited to the following unless it departs from the gist thereof.

[Measurement of Emission Spectrum]

The emission spectrum was measured using a phosphorescence spectrophotometer FP8500 (manufactured by JASCO Corporation) under the following measurement conditions. ·Light source: xenon lamp·Excitation wavelength: 455 nm·Measurement wavelength range: 380 nm to 780 nm·Measurement interval: 1.0 nm

The values of the chromaticity coordinates were calculated based on emission spectrum data from 380 nm to 780 nm using a CIE 1931 XYZ color matching functions.

[Measurement of Quantum Efficiency]

The quantum efficiency was calculated based on the emission spectrum measured using a phosphorescence spectrophotometer FP8500 (manufactured by JASCO Corporation) under the following measurement conditions. ·Light source: xenon lamp·Excitation wavelength: 455 nm·Measurement wavelength range: 380 nm to 780 nm·Measurement interval: 1.0 nm

[Phosphor Blending Simulation]

A white spectrum satisfying a specific chromaticity coordinate point when combining a spectrum of a blue LED chip emitting light at 449 nm with any phosphor was created virtually based on information on an excitation emission spectrum, internal quantum efficiency, and absorption efficiency of excitation light of each phosphor measured, and a simulation was conducted to estimate a phosphor blending ratio at this time.

Based on the obtained white spectrum, spectral efficiency (LER), i.e., a luminous flux (Lm) per energy (Wopt) of the emission spectrum, and a color rendering index of R1 to R15 were calculated.

<Production of Phosphor>

[Phosphor 1]

An exemplary red phosphor used in a light-emitting device according to an embodiment of the present invention or Comparative Examples was produced.

With reference to JP2017-008130A and Chemistry of Materials 2019 31 (12), 4614-4618, or the like, nitrides of respective elements were mixed such that the ratio of Sr:Li:Al was approximately 1:1:3, the mixture was charged into a boron nitride crucible, and the container was sealed, followed by heating at 1000°C for 5 hours under a nitrogen gas atmosphere, to give phosphor 1.

[Phosphors 2 to 9 and Reference Phosphor]

Phosphors 2 to 8 were obtained in the same manner as phosphor 1, except that a nitride raw material containing Ga was appropriately used such that the composition of the phosphor was the composition as shown in Table 1, and the firing temperature was set to 845°C. In addition, a CASN phosphor (BR-101/J, manufactured by Mitsubishi Chemical Corporation) having an emission peak wavelength of 646 nm was prepared as a reference phosphor.

The characteristics of phosphors 1 to 9 are shown in Table 1, and the emission spectrum of each phosphor when excited with light at 449 nm is shown in Fig. 1A and Fig. 1B. In addition, normalized emission spectra of the reference phosphor and phosphors 1, 2, 5, 8, and 9 are shown in Fig. 2.

Note that powder X-ray diffraction patterns of phosphors 1 to 9 all show favorable match with $SrLiAl_3N_4$.

[Table 1]

Table 1

| | Composition | Eu/[Eu+Sr] | EQE | iQE | Relative emission intensity | Emission peak wavelength/nm | FWHM/nm |
|---|---|---|---|---|---|---|---|
| Phosphor 1 | $SrLiAl_3N_4:Eu$ | 0.01 | 15% | 36% | 1.0 | 652 | 53 |
| Phosphor 2 | $SrLiAl_3N_4:Eu$ | 0.01 | 35% | 53% | 2.6 | 654 | 50 |
| Phosphor 3 | $SrLiAl_{2.4}Ga_{0.6}N_4:Eu$ | 0.01 | 44% | 62% | 3.3 | 648 | 53 |
| Phosphor 4 | $SrLiAl_{2.3}Ga_{0.7}N_4:Eu$ | 0.01 | 39% | 56% | 3.1 | 647 | 53 |
| Phosphor 5 | $SrLiAl_{2.1}Ga_{0.9}N_4:Eu$ | 0.01 | 33% | 48% | 2.6 | 643 | 54 |
| Phosphor 6 | $SrLiAl_{1.95}Ga_{1.05}N_4:Eu$ | 0.01 | 32% | 52% | 2.4 | 641 | 55 |
| Phosphor 7 | $SrLiAl_{1.8}Ga_{1.2}N_4:Eu$ | 0.02 | 30% | 46% | 2.3 | 639 | 55 |
| Phosphor 8 | $SrLiAl_{1.8}Ga_{1.2}N_4:Eu$ | 0.01 | 26% | 44% | 2.0 | 637 | 56 |
| Phosphor 9 | $SrLiAl_{1.5}Ga_{1.5}N_4:Eu$ | 0.01 | 21% | 45% | 1.3 | 633 | 59 |

<Comparative Example 1, Reference Example 1, and Examples 1 to 8>

Assuming that a SCASN phosphor (BR-620/A, manufactured by Mitsubishi Chemical Corporation) which has an emission peak wavelength of 620 nm and does not satisfy neither formula [1] nor formula [2] was used as a first red phosphor, each phosphor shown in Table 1 or a CASN phosphor having an emission peak wavelength of 646 nm (BR-101/J, manufactured by Mitsubishi Chemical Corporation) was used as a second red phosphor, and a LuAG phosphor (BG-801/B4, manufactured by Mitsubishi Chemical Corporation) was used as a green phosphor, amounts of the green phosphor and the first and second red phosphors were adjusted based on the phosphor blending simulation method described above such that an average color rendering index Ra of 90 or more was satisfied and CIE chromaticity coordinates matched coordinates (0.437, 0.404) of 3000 K white light on the Planck curve, and the characteristics of the obtained white emission spectrum were compared.

Regarding the white LEDs in Comparative Example 1 and Examples 1 to 8, Fig. 3A to Fig. 3D show the white emission spectra normalized with the maximum emission intensity in a wavelength region of 480 nm to 780 nm as 1. In addition, Fig. 4A and Fig. 4B show the emission spectra shown in Fig. 3A to Fig. 3D and a similarly drawn emission spectrum of the white LED in Reference Example 1. Further, Table 2 shows the results of calculating the emission characteristics from each spectrum.

<Comparative Example 2, Reference Example 2, and Examples 9 to 16>

Next, simulations were conducted in the same manner as in Comparative Example 1, Reference Example 1, and Examples 1 to 8, except that as Comparative Example 2, Examples 9 to 16, and Reference Example 2, the CIE chromaticity coordinates were made to match coordinates (0.380, 0.377) of 4000 K white light on the Planck curve.

Regarding the white LEDs in Comparative Example 2 and Examples 9 to 16, Fig. 5A to Fig. 5D show the white emission spectra normalized with the maximum emission intensity in a wavelength region of 480 nm or more and 780 nm or less as 1. In addition, Fig. 6A and Fig. 6B show enlarged emission spectra of the emission spectra shown in Fig. 5A to Fig. 5D and a similarly drawn emission spectrum of the white LED in Reference Example 2. Further, Table 3 shows results of calculating the emission characteristics from each spectrum.

Note that in Table 2 and Table 3, "700 nm/600 nm to 700 nm maximum value" and "600 nm/600 nm to 700 nm maximum value" indicate relative values of the emission intensities at 700 nm and 600 nm, respectively, when the maximum emission intensity in a wavelength region of 600 nm to 700 nm in each emission spectrum is set to 1.

In addition, in Table 2 and Table 3, "ratio/% by weight" of a phosphor is a weight proportion of each phosphor when a total weight of the phosphors is 100%, "Green" is the LuAG phosphor, "Red 1" is the above-described first red phosphor, and "Red 2" is the above-described second red phosphor.

[Table 2]

Table 2

| | Light source wavelength/ nm | Green (LuAG) ratio/% by weight | Red 1 (SCASN) ratio/% by weight | Red 2 type | Red 2 ratio/ % by weight | LER Lm/Wopt | Ra | R9 | 700 nm/600 nm to 700 nm maximum value | 600 nm/600 nm to 700 nm maximum value |
|---|---|---|---|---|---|---|---|---|---|---|
| Comparative Example 1 | 449 | 32.1% | 0.0% | Phosphor 1 | 67.9% | 259.5 | 90 | 89 | 0.28 | 0.50 |
| Example 1 | 449 | 78.8% | 6.4% | Phosphor 2 | 14.8% | 287.5 | 93 | 69 | 0.25 | 0.83 |
| Example 2 | 449 | 83.3% | 7.5% | Phosphor 3 | 9.2% | 307.7 | 92 | 53 | 0.18 | 0.96 |
| Example 3 | 449 | 82.4% | 7.0% | Phosphor 4 | 10.6% | 309.1 | 92 | 53 | 0.17 | 0.94 |
| Example 4 | 449 | 80.5% | 5.9% | Phosphor 5 | 13.7% | 312.2 | 92 | 53 | 0.16 | 0.92 |
| Example 5 | 449 | 74.5% | 5.1% | Phosphor 6 | 20.4% | 315.8 | 91 | 51 | 0.14 | 0.90 |
| Example 6 | 449 | 70.9% | 2.9% | Phosphor 7 | 26.2% | 312.8 | 93 | 63 | 0.13 | 0.83 |
| Example 7 | 449 | 59.9% | 2.8% | Phosphor 8 | 32.2% | 317.6 | 91 | 54 | 0.13 | 0.87 |
| Example 8 | 449 | 41.9% | 0.0% | Phosphor 9 | 58.1% | 328.8 | 91 | 46 | 0.09 | 0.87 |
| Reference Example 1 | 449 | 82.6% | 3.5% | $CaAlSiN_3$:Eu | 13.9% | 289.3 | 94 | 60 | 0.22 | 0.95 |

CIE chromaticity coordinates: (0.437, 0.404), color temperature: 3000 K

22

[Table 3]

Table 3

| | Light source wavelength/ nm | Green (LuAG) ratio/% by weight | Red 1 (SCASN) ratio/% by weight | Red 2 type | Red 2 ratio/ % by weight | LER Lm/Wopt | Ra | R9 | 700 nm/ 600 nm to 700 nm maximum value | 600 nm/ 600 nm to 700 nm maximum value |
|---|---|---|---|---|---|---|---|---|---|---|
| Comparative Example 2 | 449 | 35% | 0% | Phosphor 1 | 66% | 274.0 | 88 | 97 | 0.28 | 0.60 |
| Example 9 | 449 | 81% | 6% | Phosphor 2 | 13% | 295.4 | 91 | 65 | 0.25 | 0.96 |
| Example 10 | 449 | 85% | 7% | Phosphor 3 | 8% | 309.4 | 91 | 54 | 0.17 | 1.00 |
| Example 11 | 449 | 84% | 6% | Phosphor 4 | 9% | 310.4 | 91 | 54 | 0.17 | 1.00 |
| Example 12 | 449 | 82% | 5% | Phosphor 5 | 13% | 310.3 | 91 | 61 | 0.16 | 0.96 |
| Example 13 | 449 | 77% | 5% | Phosphor 6 | 18% | 315.1 | 91 | 53 | 0.14 | 0.98 |
| Example 14 | 449 | 74% | 3% | Phosphor 7 | 23% | 312.9 | 92 | 65 | 0.13 | 0.91 |
| Example 15 | 449 | 67% | 2% | Phosphor 8 | 31% | 314.1 | 91 | 64 | 0.13 | 0.90 |
| Example 16 | 449 | 46% | 0% | Phosphor 9 | 54% | 324.0 | 91 | 51 | 0.09 | 0.94 |
| Reference Example 2 | 449 | 85% | 5% | CASN | 10% | 300.8 | 91 | 50 | 0.26 | 1.00 |
| CIE chromaticity coordinates: (0.380, 0.377), color temperature: 4000 K | | | | | | | | | | |

It can be seen that Example 1 is improved in R9 with maintaining the LER almost the same as in Reference Example 1, and red color rendering is improved. A similar tendency is confirmed in a comparison between Example 9 and Reference Example 2.

It can be seen the white LEDs in Examples 1 to 8 and the white LEDs in Examples 9 to 16 can provide white light with significantly improved LER in the specifications of Ra ≥ 90 and R9 ≥ 50, compared to the white LEDs in Comparative Example 1 and Reference Example 1 and the white LEDs in Comparative Example 2 and Reference Example 2, respectively.

In addition, as can be seen from these figures, the light-emitting device according to the present invention has a sharp peak in the red region and can reduce the emission intensity in a wavelength region of 700 nm or the like, where the relative visibility is low, and a light-emitting device having high color rendering or red color reproducibility and high conversion efficiency can be provided.

As shown above, according to the present embodiment, it is possible to provide a phosphor having a favorable emission peak wavelength, a narrow full width at half maximum in the emission spectrum, and/or a high emission intensity, and when this phosphor is contained, it is possible to provide a light-emitting device, an illumination device, an image display device, and/or an indicator lamp for a vehicle which has favorable color rendering or color reproducibility and favorable conversion efficiency.

Although various embodiments have been described above with reference to the drawings, it goes without saying that the present invention is not limited to such examples. It is clear that those skilled in the art can come up with various changes or modifications within the scope of the claims, and it is understood that these also naturally fall within the technical scope of the present invention. In addition, each of the constituent elements in the above embodiments may be

**EP 4 645 396 A1**

freely combined without departing from the spirit of the invention.

Note that the present application is based on Japanese patent application No. 2022-210189 filed on December 27, 2022, the content of which is incorporated by reference into the present application.

INDUSTRIAL APPLICABILITY

The light-emitting device according to the present invention is favorable in any one or more of color rendering, color reproducibility, conversion efficiency, safety, and a contrast, and can be thus used for an illumination device, an image display device, and an indicator lamp for a vehicle.

**Claims**

1. A light-emitting device having at least one or more light emission colors having a correlated color temperature of 4000 K or lower, the light-emitting device comprising:

    a light-emitting element including a first luminescent material and a second luminescent material which emits visible light by irradiation with light from the first luminescent material,
    wherein the second luminescent material contains at least one or more phosphors having an emission peak in a wavelength region of 450 nm or more and less than 600 nm, and one or more other phosphors having an emission peak wavelength in a wavelength region of 600 nm or more and 700 nm or less,
    in at least one of the light emission colors having the correlated color temperature of 4000 K or lower, when an emission intensity at a wavelength $\lambda 1$ where an emission intensity of an emission spectrum is maximum at 600 nm or more and 700 nm or less is set to A, and an emission intensity at 700 nm is set to C, C/A is 0.25 or less, and the one or more other phosphors having the emission peak wavelength in the wavelength region of 600 nm or more and 700 nm or less include at least a phosphor containing a crystal phase having a composition represented by the following formula [1]:

$$Re_xMA_aMB_bMC_cN_dX_e \qquad [1]$$

    wherein in formula [1], MA includes one or more elements selected from the group consisting of Sr, Ca, Ba, Na, K, Y, Gd, and La,
    MB includes one or more elements selected from the group consisting of Li, Mg, and Zn,
    MC includes one or more elements selected from the group consisting of Al, Si, Ga, In, and Sc,
    X includes one or more elements selected from the group consisting of F, Cl, Br, and I,
    Re includes one or more elements selected from the group consisting of Eu, Ce, Pr, Tb, and Dy, and
    a, b, c, d, e, and x respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2.$$

2. The light-emitting device according to claim 1, wherein when an emission intensity at 600 nm is set to B, B/A is 0.60 or more.

3. A light-emitting device having at least one or more light emission colors having a correlated color temperature of 4000 K or lower, the light-emitting device comprising:

a light-emitting element including a first luminescent material and a second luminescent material which emits visible light by irradiation with light from the first luminescent material,
wherein the second luminescent material contains at least one or more phosphors having an emission peak in a wavelength region of 450 nm or more and less than 600 nm, and one or more other phosphors having the emission peak wavelength in the wavelength region of 600 nm or more and 700 nm or less, and
in at least one of the light emission colors having the correlated color temperature of 4000 K or lower, when an emission intensity at a wavelength $\lambda 1$ where an emission intensity of an emission spectrum is maximum at 600 nm or more and 700 nm or less is set to A, an emission intensity at 600 nm is set to B, and an emission intensity at 700 nm is set to C, B/A is 0.60 or more and C/A is 0.20 or less.

4. The light-emitting device according to claim 1 or 3, wherein
in at least one of the light emission colors having the correlated color temperature of 4000 K or lower, when an emission intensity at a wavelength where the emission intensity of the emission spectrum is a local minimum in a wavelength region equal to or greater than an emission peak wavelength $\lambda 2$ of excitation light is set to D, a ratio D/A of the emission intensity D to the emission intensity A is 0.15 or more.

5. The light-emitting device according to claim 1 or 3, wherein
in at least one of the light emission colors having the correlated color temperature of 4000 K or lower, the emission intensity of the emission spectrum continuously decreases from the wavelength $\lambda 1$ to 700 nm.

6. The light-emitting device according to claim 1 or 3, wherein a proportion of the one or more other phosphors having the emission peak wavelength in the wavelength region of 600 nm or more and 700 nm or less is 45 % by weight or less with respect to the second luminescent material.

7. The light-emitting device according to claim 1 or 3, further comprising a plurality of light-emitting elements having different light emission colors or color temperatures and a dimming device, and capable of exhibiting two or more different light emission colors.

8. The light-emitting device according to claim 1 or 3, wherein the one or more other phosphors having the emission peak wavelength in the wavelength region of 600 nm or more and 700 nm or less comprise a phosphor which does not substantially include Mn.

9. The light-emitting device according to claim 1 or 3, wherein the one or more other phosphors having the emission peak wavelength in the wavelength region of 600 nm or more and 700 nm or less comprise a phosphor which exhibits an emission peak wavelength in a wavelength region of 600 nm or more and 648 nm or less.

10. The light-emitting device according to claim 1 or 3, wherein the one or more other phosphors having the emission peak wavelength in the wavelength region of 600 nm or more and 700 nm or less comprise a phosphor having internal quantum efficiency of 30% or more.

11. The light-emitting device according to claim 1 or 3, wherein the one or more other phosphors having the emission peak wavelength in the wavelength region of 600 nm or more and 700 nm or less comprise a phosphor having a full width at half maximum in the emission spectrum of 57 nm or less.

12. The light-emitting device according to claim 1 or 3, wherein the one or more other phosphors having the emission peak wavelength in the wavelength region of 600 nm or more and 700 nm or less comprise a phosphor having a full width at half maximum in the emission spectrum of 20 nm or more.

13. The light-emitting device according to claim 1 or 3, wherein the one or more other phosphors having the emission peak wavelength in the wavelength region of 600 nm or more and 700 nm or less comprise a phosphor having an emission peak wavelength x (nm) and a full width at half maximum y (nm) in the emission spectrum satisfying a relationship: $y \leq 184-0.2x$.

14. The light-emitting device according to claim 1 or 3, wherein the one or more other phosphors having the emission peak wavelength in the wavelength region of 600 nm or more and 700 nm or less comprise at least a phosphor containing a crystal phase having a composition represented by the following formula [2]:

$$Re_xMA_aMB_b(Al_{1-y}MC'_y)_cN_dX_e \qquad [2]$$

wherein in formula [2], MA includes one or more elements selected from the group consisting of Sr, Ca, Ba, Na, K, Y, Gd, and La,

MB includes one or more elements selected from the group consisting of Li, Mg, and Zn,

MC' includes one or more elements selected from the group consisting of Si, Ga, In, and Sc,

X includes one or more elements selected from the group consisting of F, Cl, Br, and I,

Re includes one or more elements selected from the group consisting of Eu, Ce, Pr, Tb, and Dy, and

a, b, c, d, e, x, and y respectively satisfy the following expressions:

$$0.7 \leq a \leq 1.3$$

$$0.7 \leq b \leq 1.3$$

$$2.4 \leq c \leq 3.6$$

$$3.2 \leq d \leq 4.8$$

$$0.0 \leq e \leq 0.2$$

$$0.0 < x \leq 0.2$$

$$0.0 < y \leq 1.0.$$

15. The light-emitting device according to claim 1 or 3, wherein the one or more phosphors having the emission peak in the wavelength region of 450 nm or more and less than 600 nm comprise any one or more of a garnet type phosphor, a silicate type phosphor, a nitride phosphor, and an oxynitride phosphor.

16. An illumination device comprising the light-emitting device according to claim 1 or 3 as a light source.

17. An image display device comprising the light-emitting device according to claim 1 or 3 as a light source.

18. An indicator lamp for a vehicle comprising the light-emitting device according to claim 1 or 3 as a light source.

*FIG. 1A*

*FIG. 1B*

## FIG. 2

## FIG. 3A

## FIG. 3B

## FIG. 3C

## FIG. 3D

## FIG. 4A

*FIG. 4B*

*FIG. 5A*

## FIG. 5B

## FIG. 5C

## FIG. 5D

## FIG. 6A

FIG. 6B

## INTERNATIONAL SEARCH REPORT

| International application No. |
|---|
| **PCT/JP2023/028196** |

| A. | CLASSIFICATION OF SUBJECT MATTER |
|---|---|

*H01L 33/50*(2010.01)i; *C09K 11/08*(2006.01)i; *C09K 11/59*(2006.01)i; *C09K 11/61*(2006.01)i; *C09K 11/62*(2006.01)i; *C09K 11/64*(2006.01)i; *C09K 11/79*(2006.01)i; *C09K 11/80*(2006.01)i; *C09K 11/85*(2006.01)i; *F21K 9/60*(2016.01)i; *F21K 9/64*(2016.01)i; *F21S 41/125*(2018.01)i; *F21S 41/141*(2018.01)i; *F21S 41/176*(2018.01)i; *F21V 9/38*(2018.01)i; *F21W 102/00*(2018.01)n; *F21W 102/30*(2018.01)n; *F21W 103/15*(2018.01)n; *F21W 103/20*(2018.01)n; *F21W 103/35*(2018.01)n; *F21W 103/45*(2018.01)n; *F21Y 115/10*(2016.01)n

FI: H01L33/50; C09K11/08 J; C09K11/59; C09K11/61; C09K11/62; C09K11/64; C09K11/79; C09K11/80; C09K11/85; F21K9/60; F21K9/64; F21S41/125; F21S41/141; F21S41/176; F21V9/38; F21W102:00; F21W102:30; F21W103:15; F21W103:20; F21W103:35; F21W103:45; F21Y115:10 100; F21Y115:10 300; F21Y115:10 700

According to International Patent Classification (IPC) or to both national classification and IPC

| B. | FIELDS SEARCHED |
|---|---|

Minimum documentation searched (classification system followed by classification symbols)

H01L33/00-33/64

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2019-067808 A (NICHIA CORPORATION) 25 April 2019 (2019-04-25) paragraphs [0002], [0064], [0066]-[0068], [0078], [0081], [0083], [0094], fig. 5 | 3-6, 8-9, 12, 15-18 |
| Y | | 1-2, 7, 10-11, 13-14 |
| Y | JP 2016-111190 A (NICHIA CORPORATION) 20 June 2016 (2016-06-20) paragraphs [0025], [0054], fig. 1-4 | 1-2, 10-11, 13-14 |
| Y | WO 2014/119313 A1 (KABUSHIKI KAISHA TOSHIBA) 07 August 2014 (2014-08-07) paragraphs [0016]-[0018], fig. 1 | 7 |
| A | CN 103013491 A (HANGZHOU NAJING TECHNOLOGY LTD.) 03 April 2013 (2013-04-03) entire text, all drawings | 1-18 |

☐ Further documents are listed in the continuation of Box C.    ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **27 September 2023** | **10 October 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

### INTERNATIONAL SEARCH REPORT
**Information on patent family members**

International application No.

**PCT/JP2023/028196**

| Patent document cited in search report | | | Publication date (day/month/year) | Patent family member(s) | Publication date (day/month/year) |
|---|---|---|---|---|---|
| JP | 2019-067808 | A | 25 April 2019 | US 2019/0097098 A1 paragraphs [0003], [0092], [0094]-[0096], [0104], [0107], [0109], [0116], fig. 5 EP 3461873 A1 CN 109599473 A | |
| JP | 2016-111190 | A | 20 June 2016 | (Family: none) | |
| WO | 2014/119313 | A1 | 07 August 2014 | EP 2953174 A1 paragraphs [0016]-[0018], fig. 1 | |
| CN | 103013491 | A | 03 April 2013 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007291352 A
- JP 2017008130 A
- JP 2022210189 A

**Non-patent literature cited in the description**

- *J. Mater. Chem. C*, 2015, vol. 3
- *Issue*, vol. 21, 5484-5489
- *Chemistry Letters*, 2006, vol. 35 (3), 334-335
- *Chemistry of Materials*, 2019, vol. 31 (12), 4614-4618